Europäisches Patentamt

European Patent Office

Office européen des brevets

(19)

(11) Publication number: **0 379 339**
**A2**

## EUROPEAN PATENT APPLICATION

(12)

(21) Application number: **90300451.3**

(22) Date of filing: **17.01.90**

(51) Int. Cl.5: **H05K 3/34, B05D 1/04**

(30) Priority: **17.01.89 JP 8321/89**

(43) Date of publication of application:
**25.07.90 Bulletin 90/30**

(84) Designated Contracting States:
**AT BE CH DE ES FR GB GR IT LI LU NL SE**

(71) Applicant: **NORDSON CORPORATION**
**28601 Clemens Road**
**Westlake Ohio 44145-1148(US)**

(72) Inventor: **Shimada, Takeji**
**2-5-15-610, Honcho**
**Kawaguchi-Shi, Saitama-Ken(JP)**

(74) Representative: **Allen, Oliver John Richard et al**
**Lloyd Wise, Tregear & Co. Norman House**
**105-109 Strand**
**London, WC2R 0AE(GB)**

(54) **Method and apparatus for applying liquid solder resist to a printed circuit board.**

(57) A method and apparatus for applying liquid solder resist to a printed circuit board are described. Liquid solder resist is sprayed by an airless spray gun onto the board. An electrode charged to between 20 and 30 kV is provided between the gun and the board and a grounded metallic screen is mounted below the board. The electrode is distanced from the central axis of the orifice of the gun nozzle. The relative positions of the nozzle, electrode, board and screen are carefully controlled and are preferably set within specified limits. An even coating of the solder resist on the board can be achieved.

EP 0 379 339 A2

## Method and Apparatus for applying Liquid Solder Resist to a Printed Circuit Board

This invention relates to a method and apparatus for the application of liquid solder resist to the wiring patents on a printed circuit board.

In order to apply a solder resist for a wiring pattern on a printed-circuit board to prevent molten solder from spreading onto the wiring pattern during soldering operations, a process referred to as "the dry film method" is widely employed. In the dry film method, a film of photosensitive liquid solder resist (hereinafter referred to as the solder resist) is affixed over the surface of the printed circuit board. Printed circuit boards have many wirings thereon, that is, strips of copper foil pasted on the pattern face, holes being provided for the insertion of the feet of integrated circuits etc. A film of solder resist is pasted upon the pattern face.

A film (artwork) on which the required wiring pattern is drawn is put on the film face and then exposed to ultraviolet rays whereby the wiring pattern is cured. The unhardened part of the film is then peeled off. As a result the wiring pattern is coated with the hardened film which prevents flow of solder in the soldering of the feet of integrated circuits etc inserted in the through holes of the printed circuit board.

The dry film method is very expensive because it makes use of relatively expensive material and is difficult to automate. Lately printed circuit board makers have purchased solder resist and direct coating methods for solder resist are now therefore being employed.

The type of printed circuit board which has to be coated has a high density wiring pattern, that is, there are large amount of wirings per unit area. An example of this is a DIP-dual inline package in which the space between adjacent pin holes is 100 mil (2.54mm). The number of wires between the holes is referred to as the fine pattern degree. DIP's with two wires between each pair of holes are well known as are DIP's with three wires between a pair of holes. The wires consist of printed filiform copper foil. The purpose of applying solder resist is to prevent solder from flowing and contacting the copper foil wires during soldering of the feet of a component into the holes of the printed circuit board.

Known methods for coating printed circuit boards with liquid solder resist included those referred to as screen printing, roll coating, curtain coating and air spraying. These method all exhibit various problems in use.

The screen print method is what is referred to as a mimeograph method in which liquid solder resist is pushed through a screen with a roller and thereby printed onto the printed circuit board placed under the screen. The pressure of the roller results in a thin coating at the edges of the wires. Furthermore it is difficult to force the liquid solder resist into the gaps between the wiring patterns and into contact with the surface of the printed circuit board. However, conversely, the pressure causes the liquid solder resist to enter and block up the holes in the circuit board which causes difficulties when removing the uncured liquid resist.

In the roll coating method liquid solder resist is pasted onto the surface of a printed circuit board by using a roller. This method suffers from the same drawbacks as the screen print method discussed above.

Neither of these methods allow both sides of a board to be coated in a single operation.

In the curtain coating method, liquid solder resist is allowed to fall under its own weight from a slot shaped nozzle in the form of a curtain of film coating which is lowered onto the printed circuit board. The whole upper surface of the wiring pattern is coated with the liquid solder resist but layer thinning at edges still occurs. Furthermore as the curtain of liquid solder resist descends, the solder resist is exposed to the air for a comparatively long time which causes the solvent contained therein to evaporate leading to concentration changes and consequent viscosity changes. As a result, it is necessary to install devices to constantly control these parameters which adds to the process steps and the cost.

Air spraying of liquid solder resist also results in a thin layer at the edges of the wiring. It has been found that the thickness at the edge can be a quarter to a sixth of that on the flat surfaces. To increase the coating at the edges of the wirings to a satisfactory amount requires a very thick coating of the planar surfaces which is expensive and wasteful. A further problem with the spraying method is that there is generally a large amount of over-spray which adheres to the jigs and conveyors employed to carry the printed circuit boards. Cleaning and repair of these is then required which increases the cost of the process.

Electrostatic spraying of liquid solder resist either by providing a potential difference of 50 - 100 kv between the spray head and the board to be coated which is kept at ground potential, or by employing a Bell type centrifugal spray electrostatic coater has also been proposed. However it has been found that the liquid solder resist does not adhere to the inner edges of the flanges of the through holes. This is thought to be because the charged liquid solder resist is repelled by ions of the same charge which are generated at the inner periphery of the flanges. Furthermore it has been found that there is a tendency for the liquid solder resist to form a very thick film at the edges of the printed circuit board.

A method of applying liquid solder resist to a printed circuit board in accordance with the invention comprises spraying liquid solder resist from the nozzle of at least one airless liquid spray gun, directing air at the liquid solder resist emitted from the gun(s) to produce a desired spray pattern, positioning an electrode between the or each gun nozzle and the printed circuit board at a distance from the central axis of the nozzle, connecting the electrode(s) to a voltage source and positioning a grounded metallic screen on the other side of the printed circuit board from the spray gun(s).

An apparatus for applying liquid solder resist to a printed circuit board in accordance with the invention comprises at least one airless spray gun, at least one auxiliary nozzle associated with each gun for directing air at liquid sprayed therefrom to produce a desired spray pattern, a mounting frame for a printed circuit board to be sprayed operable to hold the board in a position where it will be impinged by spray emitted from the gun(s) an electrode being provided between the nozzle of the or each spray gun and the printed circuit board at a distance from the central axis of the associated nozzle, the electrode being carried in a holder, circuit means for connecting the electrode to a voltage source, and a grounded metallic screen provided on the other side of the printed circuit board from the spray gun(s).

It has been found that with such an arrangement and with careful control very good results can be obtained.

Preferably the operation of the spray gun is controlled so that spraying is conducted as a series of timed emissions, the time between each emission also being controlled. This type of spraying is known as "stitching". The spray pattern, when stitching is carried out, is formed into a series of stripes and it has been found that air is dragged into the space between the stripes which causes the solvent in the liquid solder resist to evaporate. Evaporation of the solvent increases the viscosity of the solder resist which reduces its tendency to flow after impingement on the printed circuit board. This reduced tendency to flow prevents the formation of a thin layer at the edge of the wirings as was found with the known methods.

Preferably the voltage to which the electrode is charged is between 20 and 30 kv. This is less than normal operating voltages which are generally between 50 and 100 kv. It has been found that with a voltage of this degree there is a decreased tendency for repulsion of the resist at the inner edge of the holes through the circuit board and the whole of the flanges of the board can be coated.

In a preferred embodiment the distance between the or each nozzle tip and the printed circuit board is adjusted to be between 180 mm, the distance between the or each nozzle tip and the associated electrode is adjusted to be between 50 and 100 mm and the distance between the or each electrode and the central axis of the associated nozzle measured transversely to the axis is adjusted to be between 20 and 100 mm. With these relative positionings, optimum results have been achieved, that is, even thickness of coating and good penetration between the wirings but without blockage of holes. The grounded metallic screen is preferably positioned within 30 mm of the printed circuit board.

The holder for the electrode(s) may be arranged to be movable along two orthogonal axes, preferably transverse and parallel to the central axis of the associated nozzle to adjust the distance between the nozzle and the electrode and between the nozzle central axis and the electrode.

The mounting frame, provided for a printed circuit board to be sprayed, is preferably pivotally connected or hinged to a support which is carried on a conveyor, the conveyor path being such as to cause the board to be carried below the gun(s). Means may be provided for rotating the frame relative the support to vary the orientation of the printed circuit board held in the frame. This allows an arrangement where the conveyor carries a board past two guns, the board being inverted between the guns so that both sides of the board are sprayed.

The invention will now be further described by way of example with reference to the accompanying drawings in which:-

Figure 1 is a side view, partly sectional, of an apparatus in accordance with the invention and illustrates the steps of a method in accordance with the invention;

Figure 2 is a simplified perspective view of another embodiment of an apparatus in accordance with the invention similar to that shown on Figure 1 but with a plurality of spray guns;

Figure 3A and 3B respectively show the coating produced by a method in accordance with the invention, the spraying being stitched, immediately after deposition of a coating and sometime later;

Figure 4 is a vertical section through part of a printed circuit board which has had liquid solder resist applied thereto by a method in accordance with the invention;

Figure 5 is a schematic view of an airless spray gun performing stitched spraying;

Figure 6 is a side view of a preferred embodiment of an apparatus in accordance with the invention;

Figure 7 is a view along line B-B of the apparatus of Figure 6;

Figure 8 is a view along line A-A of the apparatus of Figure 6;

Figure 9 illustrates an alternative embodiment of an apparatus in accordance with the invention similar to that shown in Figure 6 but with the printed circuit board held vertically during spraying;

Figure 10 is an end view from one end of the apparatus shown in Figure 9;

Figure 11 is a simplified side view of a third embodiment of an apparatus in accordance with the invention;

Figure 12 is an enlarged view of part of an example of a printed circuit board;

Figure 13 is a section through the printed circuit board part of Figure 12;

Figure 14A illustrates the known screen printing method;

Figure 14B is an enlarged view of the portion contained in circle E of Figure 14A;

Figure 15A illustrates the known curtain coating method;

Figure 15B is an enlarged view of the portion enclosed in circle G of Figure 15A;

Figure 16 is a section through a printed circuit board which has had liquid spray resist applied thereto by the known air spray method and

Figure 17 is a section through a printed circuit board which has had liquid solder resist applied thereto by a known electrostatic spraying method.

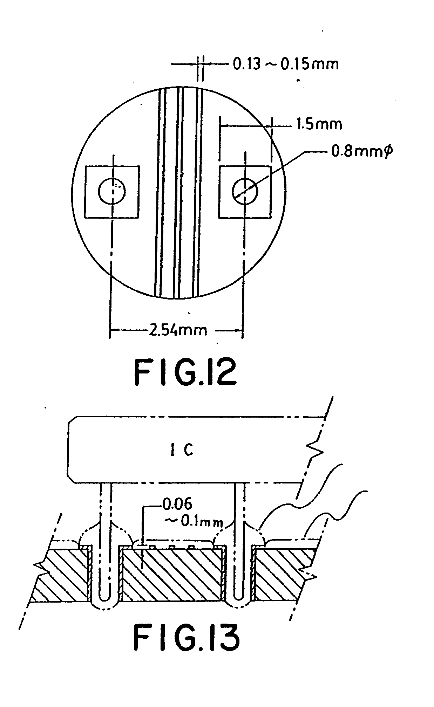

Figure 12 and Figure 13 show an example of a printed circuit board known as a DIP-dual in line package. The distance between the centre of two adjacent holes is 100 mil (2.54mm). As shown in Figure 12 three wires are positioned between these holes, the width of each of the wires, which are strips of copper foil, being 0.13 - 0.15 mm. The holes themselves are 0.8mm in diameter and the distance between the opposite extremes of the flanges surrounding the hole is about 1.5 mm. As shown in Figure 13, solder resist is coated onto the board to prevent molten solder from flowing into contact with the wires during soldering of the feet of a component, for example an Integrated Circuit, the feet being inserted through the holes.

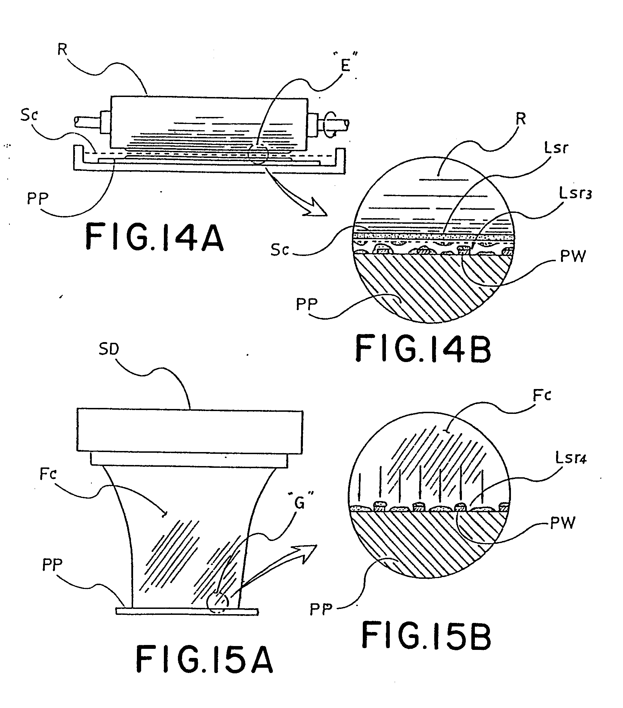

Figures 14A and 14B illustrate the known screen print method which is a mimeographic method in which liquid solder resist Lsr is pressed onto a screen Sc with a squeeze roller R to print the face of a printed circuit board PP placed thereunder. The pressure of the squeeze roller R causes a thin layer of coating to be formed at the edges of the wiring as shown in Figure 14b. Furthermore it is difficult to force solder resist into the gaps between the wiring patterns PW and into contact with the surface of printed circuit board PP. Conversely, the pressure tends to cause the liquid solder resist to enter the holes in the different circuit board which makes it difficult to remove uncured solder resist.

Figures 15A and 15B illustrate the curtain coating method in which a film of liquid solder is lowered under its own weight, in the form of a curtain Fc, onto the surface of a printed circuit board PP. The whole of the surface of the wiring pattern PW is coated with the liquid solder resist. However a thin layer is again formed at the edges of the wirings. Furthermore as the curtain Fc of liquid solder resist descends it is exposed to the air for a comparatively long time and during this time the solvent contained therein evaporates and thus the concentration of solvent in the resist changes. This results in changes in viscosity in the film and as a result apparatus is required to constantly control the process which adds to the expense.

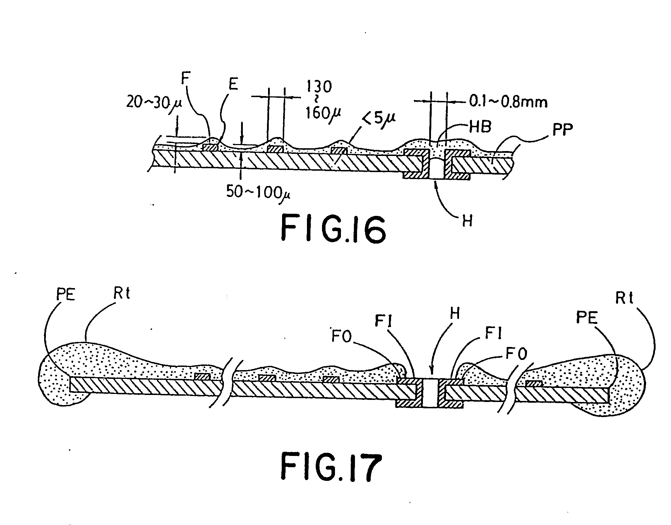

If an air spray gun is employed to coat a printed circuit board the result is as shown in Figure 16. The thickness of the coating at the edge of the copper wiring pattern is less than the thickness on the planar surfaces. It has been found that if the thickness on the flat plane F is 20 to 30 $\mu$m, the thickness on the edge section E becomes 5 $\mu$m or less. In order to achieve sufficient thickness on the edge, a very thick coating of the flat plane F is necessary which is both costly and wasteful. Moreover a large amount of overspray is produced, the coating efficiency being as low as 20%.

Figure 17 illustrates the results achieved with known electrostatic spraying methods. The liquid solder resist does not stick to the periphery FI of the through hole H at the upper and lower flanges but instead sticks to the outer peripheral edge FO very thickly. This is because ions of the same charge as that applied to the spray particles are generated at the periphery of the hole which results in repulsion of the spray particles in this area. Moreover it has been found that the liquid solder resist tends to form a very thick layer at the edge section PE of the whole printed circuit board, the thickness in this region Rt being several times the thickness across the central part of the board.

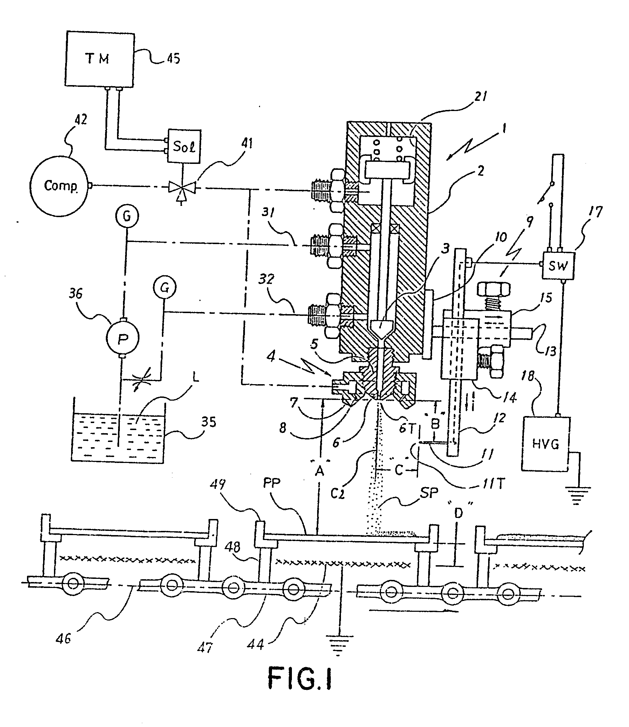

Referring now to Figure 1, an apparatus for applying liquid solder resist is illustrated in which an airless spray gun 1, comprising a barrel 2 and a nozzle 5, is employed to spray liquid solder resist towards a printed circuit board PP. A suitable spray nozzle is a cross-cut nozzle produced by the Nordson Corporation of Ohio, USA. Liquid solder resist L is transferred to the gun from a supply thereof 35 via a device 36 which pressurises it. An ON/OFF valve 3 controls the passage of liquid solder resist to the nozzle 5. Operation of the valve is controlled by a timer 45 which sends a signal to a solenoid causing a valve 41 to be opened to pass pressurised air from a supply thereof 42 into the barrel 2 of the spray gun 1 where it acts on the underside of a piston secured to the end of the valve 3 causing the valve to move upwards and thereby allow pressurised liquid solder resist to pass to the nozzle 5.

An auxiliary spray nozzle 7 is fitted to the outside of nozzle 5. This serves to direct air from air supply 42 via passages 8 towards the liquid omitted from the nozzle 5. The purpose of the auxiliary nozzle is to prevent a tail from generating in the spray pattern and to allow production of a perfect fan shaped spray pattern.

An electrode 11 is mounted between nozzle 5 and the printed circuit board PP. The electrode 11 is mounted in a holder 9 which is a recipro-sliding unit which is capable of moving the electrode both parallel to the central axis C1 of the orifice 6 of the nozzle 5 and transversely thereto, that is horizontally or vertically, as indicated by the arrows. The tip 11T of the electrode is at right angles to the central axis CI of the orifice 6 of the nozzle 5 but is distanced therefrom. The electrode is connected by circuit means to a voltage generator 18 via a switch 17.

The printed circuit board PP is held in a mounting frame 49 with its plane transverse to the central axis CI of the orifice 6 of the novel 5. The mounting frame 49 is carried via support 48 on a chain conveyor 46 which moves below the spray gun 1. A suitable conveying speed is 2 to 4 m/min. A grounded metallic screen 44 is provided below the printed circuit board between the mounting frame 49 and the chain conveyor 46.

Before commencing spraying, the relative position of the component parts is adjusted as follows. The distance from the tip 6 T of the orifice 6 to the printed circuit board PP indicated by A in Figure 1 is set to be between 100 and 180 mm. The vertical distance B from the electrode 11 to the tip 6 T of the orifice is set to be 50 to 100 mm and the distance C from the tip 11 T of the electrode to the central axis CI of the orifice 6 of the nozzle 5 is set to be between 20 to 100 mm by the recipro/sliding unit. The distance D between the lower surface of the printed circuit board PP and the grounded metallic screen 44 is set to be less than of equal to 30 mm.

The specific relative dimensions suitable for a particular case will depend upon the shape and the degree of the wiring pattern on the printed circuit board. It will also depend upon the electrical resistance value of the printed circuit board which in general is between 16 and 10 ohm/cm$^2$ and the resistance value of the liquid solder resist.

The voltage applied to the electrode is set to be between 20 to 30 kV and the timer 45 is operated to send signals to the solenoid to open and close the valve 41 such that the spraying is intermittent, the spray time and the period between each spray being of fixed duration. This type of spraying is referred to as stitched spraying. A suitable arrangement is one in which spraying is conducted for between 10 and 50 ms and the interval between omissions is 20 to 200 ms.

A suitable solder resist is a photosensitive liquid solder resist of the two component type. One with a volume intrinsic resistance of 1 M ohm/cm$^2$ or less and a viscosity of 80 cps and where the solid component comprises 30% of the volume is found to give particularly good results.

The solder resist may be pressurised to a pressure of between 40KG/cm$^2$ and 60 KG/CM$^2$ and suitable environmental conditions are a temperature of between 20 and 35° C and a relative humidity of 30 to 80%.

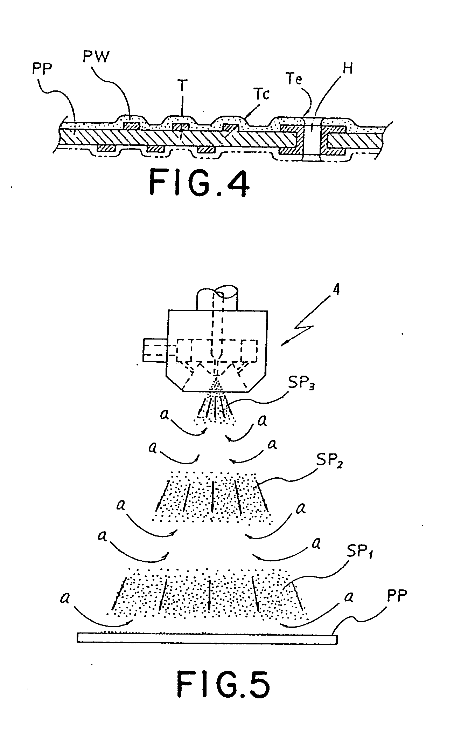

Figure 4 illustrates the results achieved if spraying is conducted in such a way as to give a thickness of 15 to 25 μm with the above described apparatus and conditions. As shown there the thickness of the coating at the edge of the wiring pattern TC is good, being between 20 to 30 μm, that is, similar to that found in the flat sections. At the through hole H liquid solder resist is coated across the whole of the flange right up to the edge Te. This is because the electrostatic voltage employed is lower than is normal which reduces the repulsion effect at the edge of the hole and allows even coating of the flange at the through hole. However blockage of the hole was not found to occur. With holes of small inner diameter (o.1 to 0.5 mm) no spray adhered to the inside of holes. With larger holes there was some adherence but loading did not occur. The spray speed is sufficient to force the liquid solder resist through the inside of the holes and prevent it from sticking thereto.

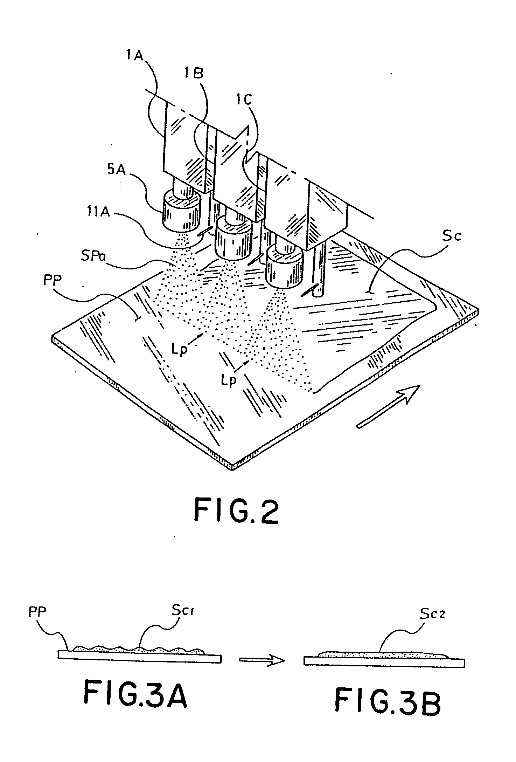

In airless spraying it is necessary to maintain a minimum liquid discharge pressure to cause atomization of the liquid which means that there is a minimum velocity for the discharge. Thus there is a minimum discharge quantity and a minimum film thickness which can be produced. By employing a stitched spraying method, with gaps between the emission of spray, the film thickness can be reduced below that possible with continuous spraying. As shown in Figure 3A with a stitched spraying method, the surface of the coating is initially in a wave like pattern. However the surface levels after about one second and the coating becomes as shown in Figure 3B, a flat film.

Furthermore with stitched spraying, the spray pattern is divided into a series of stripes SP1, SP2, SP3.... Air is dragged into the space between the stripes which comes into contact with the solvent contained in the liquid solder resist and causes it to evaporate. This increases the viscosity of the liquid solder resist and reduces its tendency to flow, thus preventing the formation of a thin layer at the edges of the wirings on the printed circuit board PP.

After spraying of one side of a board, it can be reversed and the other side sprayed. This is not possible with the known screen printing and roll coating methods since sticky liquid solder on the obverse side to that being coated would be damaged by the pressure applied in these methods.

The amount of overspray produced with the apparatus shown in Figure 1 is much less than that with known methods of applying liquid solder resist by spraying due to the provision of the electrode, the wire screen and the auxiliary air nozzles. This has great advantages since the jigs and frames for holding the printed circuit boards do not have to be cleaned so frequently. Furthermore there is less contamination of the environment.

If a wide printed circuit board is to be sprayed then a plurality of spray guns are preferably employed. These are arranged as shown in Figure 2 so that the bottom section of their spray pattern overlap to ensure full coating of the circuit board.

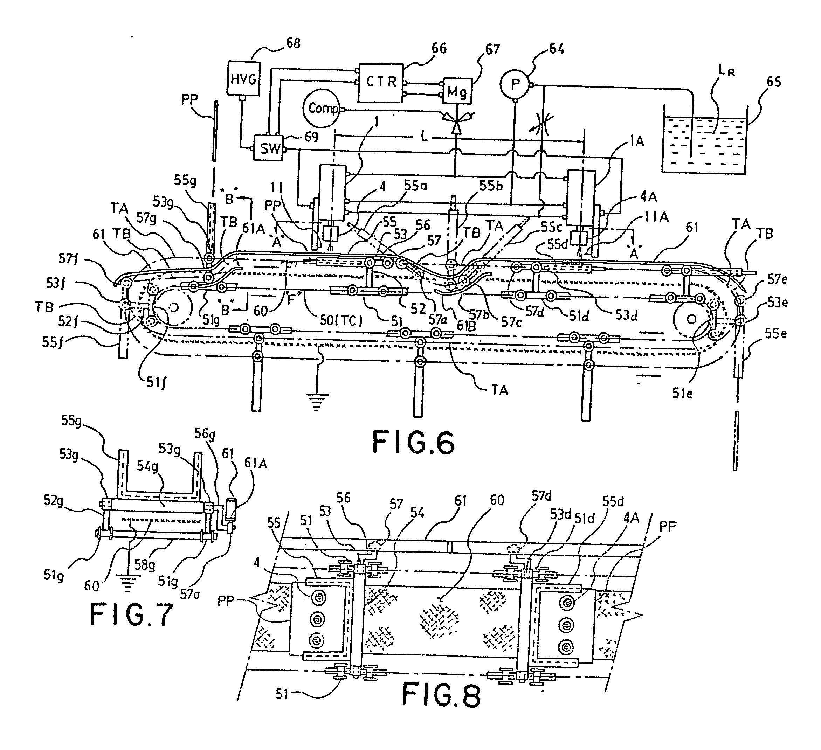

Figure 6 illustrates an apparatus the use of which allows both sides of a printed circuit board to be coated in a continuous, totally automatable process. Two spray guns 1 and 1A are employed each of which is provided with an auxiliary nozzle 4 and 4a, for directing air at liquid solder resist sprayed therefrom. The guns 1 and 1A are supplied with liquid from a supply tank 65 via a pump 64 which pressurises the liquid. A control unit 66 controls both the supply of air from a compressor Comp to the guns, to open the valves therein to pass liquid solder resist to the nozzles thereof, and, a switch 69 which connects the electrodes 11 and 11a associated with the guns to a high voltage source 68.

The guns are positioned a distance L apart above a chain conveyor 50 which moves in the direction indicated by the arrows F. In the interval between the guns the printed circuit board PP is turned over. The structure for carrying the printed circuit board will now be described. The parts thereof are referenced 51 to 61. The references are employed alone to refer to the circuit board when it has just passed below the first spray gun 1 and with consecutive letters as the holder is moved around the path defined by the conveyor 50.

A support 52, in the forms of two arms, is carried on a pair of aligned chain links 51 of the conveyor 50. A hinge 53 is installed at the top of the support 52. This comprises two blocks each mounted to the free end of a respective one the arms of the support 52. The ends of a shaft 54 on which is carried the mounting frame 55 for the printed circuit board are received in apertures in the blocks. One end of the shaft 54 is connected to one end of a Z shaped crank 56 which has a roller 57 mounted at its other end. A guide rail 61 is provided adjacent part of the conveyors path and, as the conveyor moves along this part of its path, the roller 57 is forced to follow this guide rail.

A grounded metallic screen 60 is installed between the chain links 51 of the conveyor and the shaft 54 to which the mounting frame 55, for a printed circuit board to be sprayed, is attached.

The track TB followed by the roller 57 is indicated by a line comprising a long dash and two short dashes whilst the track TA of the hinge 53 is indicated by a line comprising a long dash and a short dash. The track of the conveyor TC is also indicated with a long dash/short dash line.

An important feature of this arrangement is that the guide rail 61 is so shaped that the roller 57 is swung through 180 degrees between the two spray guns which causes the U shaped holding frame 55 also to turn through 180 degrees. The hinge 53 which is the fulcrum of this swing is combined in one body with the chain links 51 of the conveyor 50 and therefore the track TA of the hinge 53 is parallel to the conveyor path TC.

The operation of this apparatus is now described. The chain conveyor 50 travels in direction F. As it moves along the bottom straight section of its generally elliptical path, the mounting frame 55 hangs down therefrom. As the conveyor path TC begins to turn and the conveyor 50 ascends the support 52f and the hinge 53f connected thereto become horizontal. The mounting frame 55, pivotally connected to the support 52, continues to hang vertically downwards. At the same time the roller 57f attached to the mounting frame 55f comes into contact with the tip of the guide rail 61 and is forced to move generally horizontally, (see track TB). The hinge 55f continues to ascend along semi-circular track TA which is concentric with the conveyor path TC and due to the relationship between the hinge 55f and the roller 57f, the mounting frame is turned into an upright vertical position. A printed circuit board PP to be sprayed is inserted into the mounting frame 55.

The roller 57f then ascends along the guide rail 61 and onto the track TA of the hinge 53, that is, the roller 57 and the hinge 53 both follow the same straight line. This causes the mounting frame 55 which is secured to the roller 57 by crank 56 to become horizontal and the printed circuit board PP held in the frame therefore travels horizontally below the gun 1 and is sprayed from the nozzle thereof.

After the roller 57 passes below the gun 1 it is moved downwards (see 57a) along guide rail 61 whilst the hinge 53 continues along track TA. This causes the holding frame 556 to become upright.

The roller 57b then ascends and again follows the straight line path of the hinge 53d, that is, track TA. The holding frame 55d is thereby rotated into a horizontal position in which the unsprayed face of the printed circuit board PP faces upward and carried under the second gun 1A. Spray is then applied from the nozzle of gun 1A onto this unsprayed face. After spraying is complete the hinge 53 passes round the curved end path by the conveyor and the roller 57e is released from the rail 61. Movement around the curved end path causes the mounting frame 55e to swing downwards so that the printed circuit board PP which is held therein and which has had both faces sprayed is released downwards.

As illustrated in Figure 8 instead of a single spray gun 1 and 1A, a bank of three spray guns may be provided which will be arranged generally as shown in Figure 2.

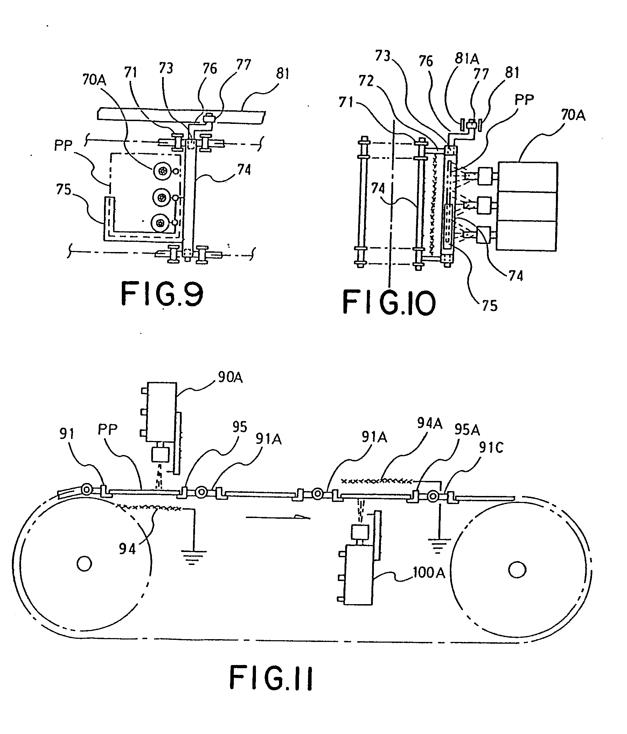

In an alternative arrangement shown in Figures 9 and 10 the conveyor follows a vertical path and the printed circuit board is held vertically during spraying. The parts are nearly identical to those described above with reference to Figures 6 to 8 and they are identified by the reference numerals employed therein but increased by 20. The guns are identified by 70A. The guide rail 81 comprises two parallel portions, the roller 77 running there between. Figure 9 is a side view and Figure 10 shows an end view.

Figure 11 illustrates an arrangement whereby both sides of the printed circuit board may be sprayed but without the necessity for inverting the printed circuit board. The circuit board PP is carried by a conveyor 91 A to C on a mounting frame 95 past a first spray gun 90A positioned above the board and then past a second spray gun 100A positioned below the board. In both cases a grounded metallic screen 94 and 94A is positioned on the opposite side of the printed circuit board from the spray gun 90A and 100A.

If desired the arrangement of Figure 11 could be modified so that the printed circuit board is carried vertically past the spray guns.

With the arrangements described above liquid solder resist can be applied over the whole surface of a printed circuit board with a constant thickness and without a thinner layer being formed at the edges of the wiring. Furthermore loading of the holes is not produced. Spraying of both faces of the printed circuit board can be achieved. Further advantages are the reduction in overspray, the greatly improved quality of the printed circuit board and the increase of output efficiency with the consequent reduction in man-days.

**Claims**

1. A method of applying liquid solder resist to a printed circuit board comprising spraying liquid solder resist from the nozzle of at least one airless liquid spray gun, directing air at the liquid solder resist emitted from the gun(s) to produce a desired spray pattern, positioning an electrode between the or each gun nozzle and the printed circuit board at a distance from the central axis of the nozzle, connecting the electrode(s) to a voltage source and positioning a grounded metallic screen on the other side of the printed circuit board from the spray gun(s).

2. A method as claimed in Claim 1 further comprising controlling the operation of the spray gun(s) so that spraying is conducted in a series of timed emissions, the time between each emission also being controlled.

3. A method as claimed in either Claim 1 or Claim 2 wherein the voltage to which the or each electrode is charged is between 20 and 30 kV.

4. A method as claimed in any preceding claim wherein the distance between the or each nozzle tip and the printed circuit board is adjusted to be between 100 and 180 mm, wherein the distance between the or each nozzle tip and the associated electrode is adjusted to be between 50 and 100 mm, wherein the distance between the or each electrode and the central axis of the associated nozzle measured transversely to the axis is adjusted to be between 20 and 100 mm.

5. A method as claimed in any preceding claim wherein the grounded metallic screen is positioned at a maximum distance of 30 mm below the surface of the printed circuit board which it faces.

6. Apparatus for applying liquid solder resist to a printed circuit board comprising at least one airless spray gun, at least one auxiliary nozzle associated with each gun for directing air at liquid sprayed therefrom to produce a desired spray pattern, a mounting frame for a printed circuit board to be sprayed operable to hold the board in a position where it will be impinged by spray emitted from the gun(s), an electrode being provided between the nozzle of the or each spray gun and the printed circuit board at a distance from the central axis of the associated nozzle, the electrode being carried in a holder, circuit means for connecting the electrode to a voltage source, and a grounded metallic screen provided on the other side of the printed circuit board from the spray gun(s).

7. Apparatus as claimed in Claim 6 wherein means are provided for so controlling the operation of the spray guns that spray is produced therefrom in a series of timed emissions, the time between each omission being also controlled.

8. Apparatus as claimed in either Claim 6 or 7 wherein the voltage generator and circuit means are arranged to charge the electrode to between 20 and 30 kV.

9. Apparatus as claimed in any one of Claims 6 to 8 wherein the or each electrode holder is movable along two orthogonal axes parallel and transverse to central axis of the associated nozzle, to adjust the distance between the nozzle and electrode and between the nozzle central axis and the electrode.

10. Apparatus as claimed in any one of Claim 6 to 9 wherein the mounting frame is hinged to a support which is carried on a conveyor, the conveyor path being such as to cause the board to be carried below the gun(s).

11. Apparatus as claimed in Claim 10 wherein means are provided for rotating the frame relative the support to vary the orientation of a printed circuit board held in the frame.

12. Apparatus as claimed in Claim 11 wherein the means for rotating the frame comprise a curved track and a roller secured to the frame which is forced to move along the curved track.

FIG.I

EP 0 379 339 A2

FIG.2

FIG.3A    →    FIG.3B

EP 0 379 339 A2

FIG.4

FIG.5

EP 0 379 339 A2

FIG.6

FIG.7

FIG.8

FIG.9

FIG.10

FIG.11

0.13 ~ 0.15mm

1.5mm

0.8mmφ

2.54mm

FIG.12

IC

0.06 ~ 0.1mm

FIG.13

EP 0 379 339 A2

FIG.14A

FIG.14B

FIG.15A

FIG.15B

EP 0 379 339 A2

20~30μ

F

E

130
～
160μ

<5μ

0.1~0.8mm

HB

PP

50~100μ

H

FIG.16

PE

Rt

FO

FI

H

FI

FO

PE

Rt

FIG.17

EP 0 379 339 A2